# EUROPEAN PATENT APPLICATION

(11) **EP 4 791 023 A1**
(43) Date of publication of application: **12.08.2026**
(21) Application number: 24876436.7
(22) Date of filing: 29.09.2024
(51) Int. Cl.: H04Q 9/00, G01R 31/382

(54) **ACQUISITION APPARATUS, BATTERY MODULE, BATTERY PACK, AND VEHICLE**

(30) Priority: 08.10.2023 CN 202322711908 U
(71) Applicant: BYD Company Limited, Shenzhen, Guangdong 518118 (CN)
(72) Inventor: CAI, Chen, Shenzhen, Guangdong 518118 (CN); ZENG, Wei, Shenzhen, Guangdong 518118 (CN); XU, Le, Shenzhen, Guangdong 518118 (CN); CAI, Dongping, Shenzhen, Guangdong 518118 (CN); MA, Aili, Shenzhen, Guangdong 518118 (CN)
(74) Representative: Taor, Simon Edward William
(86) International application number: PCT/CN2024/122269
(87) International publication number: WO 2025/077620

(57) **Abstract**

Provided is a vehicle, including a battery pack, where the battery pack includes a battery module, and the battery module includes an acquisition apparatus. The acquisition apparatus includes an acquisition chip and a transmitter. The acquisition chip is configured to electrically connect to at least one battery cell, one end of the transmitter is electrically connected to the acquisition chip, and the other end of the transmitter is configured to communicate with a receiver.

## Description

### CROSS-REFERENCE TO RELATED APPLICATIONS

This application claims priority to Chinese Patent Application No. 202322711908.0, filed with the China National Intellectual Property Administration on October 08, 2023, and entitled "ACQUISITION APPARATUS, BATTERY MODULE, BATTERY PACK, AND VEHICLE", which is incorporated herein by reference in its entirety.

### TECHNICAL FIELD

This application relates to the field of vehicle technologies, and in particular, to an acquisition apparatus, a battery module, a battery pack, and a vehicle.

### BACKGROUND

In the related art, battery packs for most electric vehicles use a wired communication manner to transmit data from battery modules to a controller of a battery management system (BMS). Specifically, an acquisition circuit board is welded to an inter-battery cell connecting sheet via a nickel sheet for voltage sampling. Adjacent acquisition circuit boards between different modules are connected via wiring harnesses and connectors for daisy-chain communication to transmit sampling information. That is, a daisy chain starts from a main negative terminal of a BMU, forms a loop between the acquisition circuit boards of the modules, and returns to a main positive terminal of the BMU. The foregoing solution results in numerous wiring harnesses and connectors inside the battery pack, leading to structural redundancy.

### SUMMARY

This application is intended to resolve at least one of technical problems existing in the prior art. In view of this, a first objective of this application is to provide an acquisition apparatus to facilitate acquisition and transmission of information of a battery cell inside a battery pack.

A second objective according to an embodiment of this application is to provide a battery module, including the acquisition apparatus according to the first objective of this application.

A third objective according to an embodiment of this application is to provide a battery pack, including the foregoing battery module.

A fourth objective according to an embodiment of this application is to provide another battery pack, including the foregoing battery module.

A fifth objective according to an embodiment of this application is to provide a vehicle, including the battery pack according to any one of the foregoing embodiments.

According to the embodiment in a first aspect of this application, the acquisition apparatus includes: an acquisition chip and a transmitter, where the acquisition chip is configured to electrically connect to at least one battery cell, the transmitter is electrically connected to the acquisition chip, and the transmitter is configured to communicate with a receiver.

According to the acquisition apparatus in the embodiment of this application, the transmitter is disposed inside the acquisition apparatus, and the transmitter is electrically connected to the acquisition chip, so that wireless communication between the transmitter and the receiver can be achieved. In this way, the use of wiring harnesses inside the battery pack provided with the acquisition apparatus can be reduced, and the space inside the battery pack is optimized, so that a communication structure inside the battery pack is simpler; and the space occupied by the acquisition apparatus inside the battery pack is reduced, so that the space inside the battery pack is larger and more battery cells can be arranged, increasing the battery capacity of the battery pack.

In some embodiments, the acquisition apparatus further includes: an acquisition circuit board, where the acquisition chip and the transmitter are both disposed on the acquisition circuit board, and the transmitter and the acquisition chip are both electrically connected to the acquisition circuit board.

In some embodiments, the acquisition circuit board is a flexible printed circuit board or a rigid printed circuit board.

In some embodiments, the acquisition apparatus further includes an antenna, where at least a portion of the antenna is disposed within a stable transmission area of differential signals emitted by the transmitter.

In some embodiments, a distance between the antenna and the transmitter is L, and L satisfies: 0≤L≤100 mm.

In some embodiments, the antenna includes a plurality of differential signal lines, and the plurality of differential signal lines communicate wirelessly with the transmitter.

In some embodiments, the antenna further includes: at least one shielding wire, where the shielding wire and the plurality of the differential signal lines are disposed side by side.

In some embodiments, there are a plurality of shielding wires, and the plurality of shielding wires are separately located on two sides of an arrangement direction of the plurality of differential signal lines.

In some embodiments, an outer side of the antenna is wrapped with a cable.

According to the embodiment in a second aspect of this application, the battery module includes: an acquisition apparatus, where the acquisition apparatus is the acquisition apparatus according to any one of the foregoing embodiments.

In some embodiments, the acquisition apparatus is disposed on the battery module; or the battery module further includes: a battery cell connecting sheet, where the battery cell connecting sheet is electrically connected to an acquisition circuit board of the acquisition apparatus.

In some embodiments, the battery module further includes: a sampling nickel sheet, where the sampling nickel sheet is disposed between the battery cell connecting sheet and the acquisition circuit board.

In some embodiments, the acquisition apparatus includes an antenna. The antenna is disposed on the battery module; or the antenna is disposed on the acquisition circuit board of the acquisition apparatus; or a mounting bracket is disposed inside the battery module, and the antenna is disposed on the mounting bracket.

In some embodiments, the battery module further includes at least one battery cell and a module housing. The battery cell is disposed inside the module housing, and the antenna is disposed on one side, away from the battery cell, of the module housing; or the antenna is disposed on one side, adjacent to the battery cell, of the module housing.

In some embodiments, the battery cell includes two terminals, the two terminals are disposed at a same end of the battery cell, and the antenna is disposed between the two terminals.

In some embodiments, the acquisition circuit board is disposed in the middle of the battery module, and the antenna is opposite to the acquisition circuit board.

In some embodiments, there are a plurality of battery cells, and the plurality of battery cells are electrically connected to at least one acquisition chip.

In some embodiments, there are a plurality of battery cells, and the plurality of battery cells are electrically connected to at least one acquisition circuit board.

According to the embodiment in a third aspect of this application, the battery pack includes: a housing, at least one battery cell, and an acquisition apparatus, where the battery cell is disposed inside the housing, the acquisition apparatus is the acquisition apparatus according to any one of the foregoing embodiments, and one end of the acquisition apparatus is electrically connected to the battery cell.

In some embodiments, the battery pack further includes an antenna, where the antenna communicates with the transmitter disposed inside the acquisition apparatus. The housing includes: a tray, and a cover plate. One side of the tray is open, the cover plate is disposed on the open side of the tray, the cover plate and the tray jointly define an accommodating cavity, the battery cell is disposed in the accommodating cavity, and the antenna is disposed on the tray or the cover plate.

In some embodiments, at least one of the cover plate and the tray includes a first housing layer and a second housing layer. The first housing layer is located on one side, away from the battery cell, of the second housing layer, and the antenna is disposed between the first housing layer and the second housing layer; or the antenna is disposed on one side, away from the second housing layer, of the first housing layer; or the antenna is disposed on one side, away from the first housing layer, of the second housing layer.

In some embodiments, an accommodating groove for accommodating at least a portion of the antenna is formed in at least one of the first housing layer and the second housing layer.

In some embodiments, the battery pack further includes a control apparatus, where the control apparatus is disposed inside the housing, the control apparatus includes a receiver, and the antenna communicates with the receiver.

In some embodiments, the control apparatus includes a main positive terminal and a main negative terminal, and the two ends of the antenna are electrically connected to the main positive terminal and the main negative terminal respectively.

According to the embodiment in a fourth aspect of this application, the battery pack includes at least one battery module and a control apparatus. The battery module is the battery module according to any one of the foregoing embodiments, an acquisition apparatus is disposed inside the battery module, and the acquisition apparatus includes a transmitter and an antenna. The control apparatus is provided with a receiver, and the receiver communicates with the transmitter via the antenna.

According to the embodiment in a fifth aspect of this application, the vehicle includes the battery pack according to any one of the foregoing embodiments.

Additional aspects and advantages of this application are partially given in the following description, partially become apparent from the following description, or are learned from the practice of this application.

### BRIEF DESCRIPTION OF DRAWINGS

The foregoing and/or additional aspects and advantages of this application become apparent and easily understandable from the description of embodiments with reference to the following accompanying drawings, in which:
FIG. 1 is a schematic diagram of a battery pack (with a cover plate) according to an embodiment of this application.
FIG. 2 is a schematic diagram of a battery pack (without a cover plate) according to an embodiment of this application.
FIG. 3 is a schematic diagram of positions of a battery cell and an acquisition apparatus according to an embodiment of this application.
FIG. 4 is a sectional view of an antenna according to an embodiment of this application.
FIG. 5 is a schematic diagram with a battery module according to an embodiment of this application.
FIG. 6 is a three-dimensional schematic diagram without a battery module according to an embodiment of this application.
FIG. 7 is a top view without a battery module according to an embodiment of this application.
FIG. 8 is a schematic diagram of an acquisition apparatus disposed on each battery cell according to an embodiment of this application.
FIG. 9 is a schematic diagram of an acquisition circuit board as a flexible printed circuit board according to an embodiment of this application.
FIG. 10 is a schematic diagram of an antenna disposed on a cover plate according to an embodiment of this application.
FIG. 11 is an enlarged view of an area P in FIG. 10.
FIG. 12 is a schematic block diagram of an acquisition apparatus according to an embodiment of this application.
FIG. 13 is a schematic block diagram of a battery pack according to an embodiment of this application.
FIG. 14 is a schematic block diagram of a vehicle according to an embodiment of this application.

### Reference numerals:

100: battery pack; 1000: vehicle
10: housing; 11: cover plate; 111: accommodating groove; 12: tray; 1111: first housing layer; 1112: second housing layer;
20: battery cell;
30: acquisition apparatus; 31: acquisition circuit board; 32: acquisition chip; 33: acquisition circuit board element; 34: transmitter;
40: battery module; 41: module housing; 42.: battery cell connecting sheet; 43: sampling nickel sheet; 401: mounting bracket; 201: terminal;
50: antenna; 51: shielding wire; 52: differential signal line;
60: control apparatus; 601: receiver

### DESCRIPTION OF EMBODIMENTS

Embodiments of this application are described in detail below. The embodiments described with reference to accompanying drawings are exemplary.

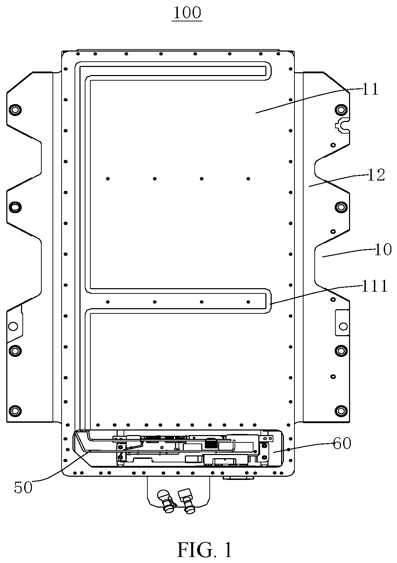

The acquisition apparatus 30 according to an embodiment of this application is described below with reference to FIG. 1 to FIG. 14, including: an acquisition chip 32 and a transmitter 34.

Specifically, as shown in FIG. 1 to FIG. 13, the acquisition chip 32 is configured to electrically connect to at least one battery cell 20, the transmitter 34 is electrically connected to the acquisition chip 32, and the transmitter 34 is configured to communicate with a receiver 601.

In this embodiment, the acquisition apparatus 30 is disposed inside the battery pack 100. The acquisition chip 32 is disposed on the acquisition apparatus 30. The acquisition chip 32 is configured to acquire data information of the battery cell 20 disposed inside the battery pack 100. The acquired data information is analyzed and processed by the acquisition chip 32. The acquisition chip 32 is electrically connected to the transmitter 34, and the transmitter 34 transmits the data information analyzed and processed by the acquisition chip 32 to the receiver 601. The receiver 601 can be disposed on a BMU (Battery Management Unit) of a distribution box or on a BMS including the BMU.

According to the acquisition apparatus 30 in the embodiment of this application, the transmitter 34 is disposed inside the acquisition apparatus 30, and the transmitter 34 is electrically connected to the acquisition chip 32, so that wireless communication between the transmitter 34 and the receiver 601 can be achieved. In this way, the use of wiring harnesses inside the battery pack 100 provided with the acquisition apparatus 30 can be reduced, and the space inside the battery pack 100 is optimized, so that a communication structure inside the battery pack 100 is simpler; and the space occupied by the acquisition apparatus 30 inside the battery pack 100 is reduced, so that the space inside the battery pack 100 is larger and more battery cells 20 can be arranged, increasing the battery capacity of the battery pack 100.

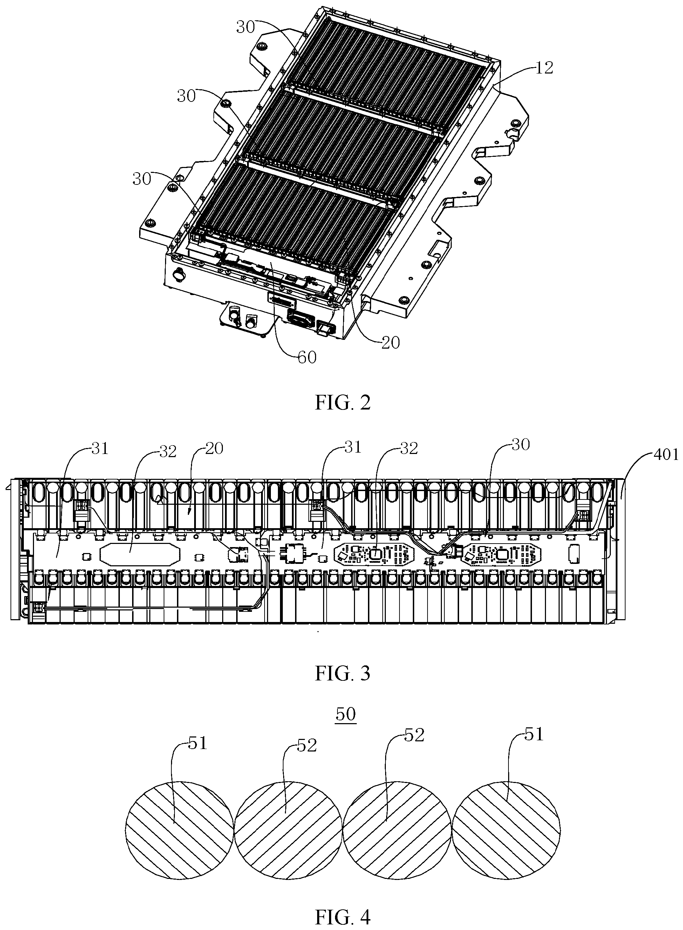

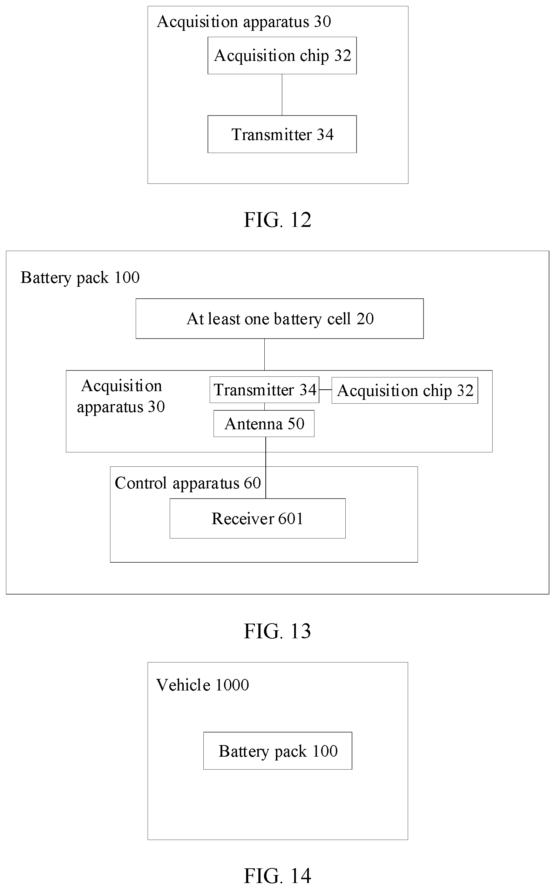

In some embodiments, as shown in FIG. 3, with reference to FIG. 12, the acquisition apparatus 30 further includes an acquisition circuit board 31, the acquisition chip 32 and the transmitter 34 are both disposed on the acquisition circuit board 31, and the transmitter 34 and the acquisition chip 32 are both electrically connected to the acquisition circuit board 31. That is, the transmitter 34 and the acquisition chip 32 are spaced apart from each other on the acquisition circuit board 31 and electrically connected to the circuit board. The circuit board is configured to electrically connect to the battery cell 20. The acquisition chip 32 acquires the data information of the battery cell 20 by means of electrical connection between the acquisition circuit board 31 and the battery cell 20. In this way, arrangement of the acquisition circuit board 31 facilitates electrical connection between the acquisition chip 32 and the transmitter 34, optimizes the arrangement positions of the acquisition chip 32 and the transmitter 34 on the acquisition apparatus 30, and facilitates achievement of electrical connection to the battery cell 20 to acquire the data information of the battery cell 20.

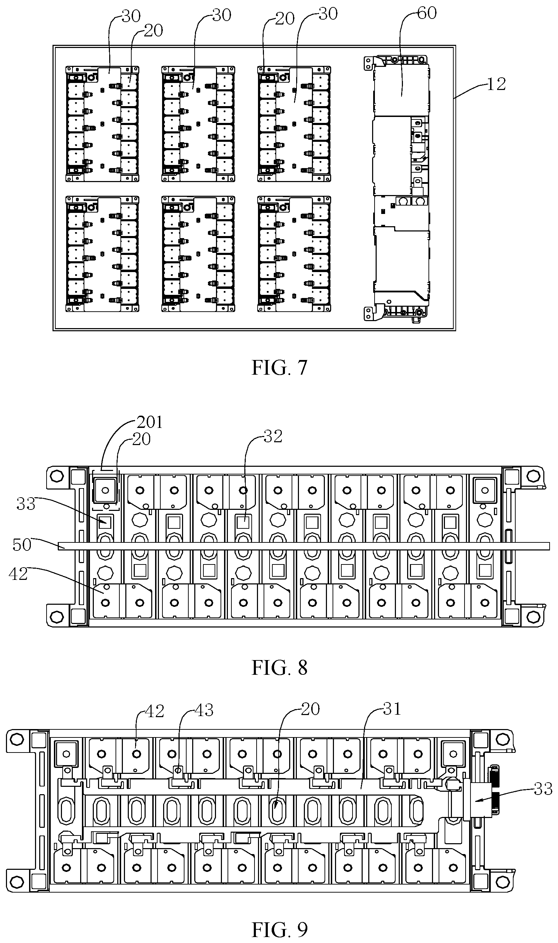

Furthermore, in the related art, a radio frequency chip is embedded inside each module and a controller of the BMS to facilitate communication connection and data transmission between each module and the BMS. As shown in FIG. 8 and with reference to FIG. 12, the acquisition chip 32 and the transmitter 34 are integrated into an acquisition element. The transmitter 34 is disposed on the acquisition chip 32, and the transmitter 34 is electrically connected to the acquisition chip 32. In this case, the acquisition chip 32 acquires the data information of the battery cell 20 in one aspect, and serves as a circuit board to be electrically connected to the transmitter 34 in another aspect, so that the acquisition chip 32 transmits the acquired data information to the transmitter 34.

Optionally, the acquisition chip 32, the acquisition circuit board 31, and the transmitter 34 are integrated into an acquisition circuit board element 33, and each battery cell 20 can correspond to one acquisition circuit board element 33. In this case, both the acquisition chip 32 and the transmitter 34 are disposed on the acquisition circuit board 31 and on a same side of the acquisition circuit board 31 in a thickness direction. One side, away from the transmitter 34, of the acquisition circuit board 31 is opposite to the battery cell 20.

Optionally, the acquisition circuit board 31 is a flexible printed circuit board or a rigid printed circuit board. The flexible printed circuit board or the rigid printed circuit board is selected on the basis of the form of the battery module 40 inside the battery pack 100. For example, when a battery module 40 is disposed inside the battery pack 100, a flexible printed circuit board can be used; when no battery module 40 is disposed inside the battery pack 100, the acquisition apparatus 30 can use a rigid printed circuit board. In this way, arrangement of the acquisition apparatus 30 inside the battery pack 100 and connection thereof to battery cells 20 of different modules are facilitated.

In some embodiments, with reference to FIG. 8 and FIG. 9 and in view of FIG. 13, the acquisition apparatus 30 further includes an antenna 50, at least a portion of the antenna 50 is disposed within a stable transmission area of differential signals emitted by the transmitter 34. That is, electromagnetic waves emitted by the transmitter 34 propagate within a certain range. The antenna 50 configured to receive electromagnetic wave signals from the transmitter 34 needs to be disposed within the range of electromagnetic wave propagation. A high-frequency current is generated in the antenna 50, and the antenna 50 converts the electromagnetic waves transmitted by the transmitter 34 into differential signals and transmits same to the receiver 601. The BMU acquires the data information of the battery cell 20 via the receiver 601 and analyzes and processes same. The antenna 50 is a wireless communication apparatus and can convert the electromagnetic waves into electrical signals. The antenna 50 can receive the electromagnetic wave signals transmitted by the transmitter 34. In this way, arrangement of the antenna 50 can facilitate signal transmission between the transmitter 34 and the receiver 601, and avoid wiring harness connections between different acquisition circuit boards 31 and between the acquisition circuit board 31 and the battery cell 20; and the antenna 50 has a wide coverage, so that the use of connectors on the acquisition circuit board 31 is reduced, the space of the acquisition apparatus 30 is optimized, and the layout of the acquisition apparatus 30 inside the battery pack 100 is facilitated.

In some embodiments, a distance between the antenna 50 and the transmitter 34 is L, and L satisfies: 0≤L≤100 mm. In this way, the distance between the antenna 50 and the transmitter 34 is defined to enable the antenna 50 to be stably disposed within the range of the electromagnetic wave signals emitted by the transmitter 34, so that the antenna 50 can acquire and form differential signals in a timely and accurate manner and transmit same to the receiver 601. For example, L=10 mm.

With reference to FIG. 4 and FIG. 12, the antenna 50 includes a plurality of differential signal lines 52, and the plurality of differential signal lines 52 communicate wirelessly with the transmitter 34. The plurality of differential signal lines 52 can acquire the electromagnetic waves emitted by transmitter 34 and form corresponding differential signals. One end, away from the transmitter 34, of the differential signal line 52 is electrically connected to the receiver 601.

With reference to FIG. 4, the antenna 50 further includes: at least one shielding wire 51, where the shielding wire 51 and the plurality of the differential signal lines 52 are disposed side by side. Arrangement of the shielding wire 51 can reduce interference of an interfering magnetic field around the antenna 50 on the electromagnetic waves received by the antenna 50 from the transmitter 34, improving the accuracy of the antenna 50 in acquiring signals. If there is no electromagnetic interference in an environment where the battery pack 100 is used, only the differential signal lines 52 are needed to meet transmission of sampling information.

In some embodiments, there are a plurality of shielding wires 51, and the plurality of shielding wires 51 are located on two sides of an arrangement direction of the plurality of differential signal lines 52. In this embodiment, there can be two shielding wires 51. The two shielding wires 51 are located on the sides, away from each other, of the two differential signal lines 52 disposed side by side. The plurality of shielding wires 51 can shield interference signals from a plurality of directions, ensuring that the antenna 50 stably receives the signals emitted by the transmitter 34 and that the differential signals inside the antenna 50 are stably transmitted.

In some embodiments, an outer side of the antenna 50 is wrapped with a cable. When the antenna 50 is mounted, cables at two ends of the antenna 50 need to be stripped, so that the electromagnetic wave signals emitted by the transmitter 34 can be received conveniently by the antenna 50 and converted into the differential signals for transmission to the BMS. The cable is a conductor cable, the conductor cable includes a microstrip or a coplanar waveguide, and the formed impedance of the antenna 50 matches with the impedance of the conductor cable.

According to the embodiment in a second aspect of this application, the battery module 40 includes: an acquisition apparatus 30, where the acquisition apparatus 30 is the acquisition apparatus 30 according to any one of the foregoing embodiments. The acquisition apparatus 30 is disposed on the battery module 40. The acquisition apparatus 30 can be configured to acquire data information of a battery cell 20 included in the battery module 40.

According to the battery module 40 of this application embodiment, by use of the foregoing acquisition apparatus 30, an internal structure of the battery module 40 can be simplified and an internal space of the battery module 40 can be optimized.

In some embodiments, with reference to FIG. 8 and FIG. 9, the acquisition apparatus 30 is disposed on the battery module 40, that is, the acquisition apparatus 30 is disposed on an inner side of the battery cell 20. For example, when a battery cell housing inside the battery module 40 is energized, an acquisition circuit board element 33 included by the acquisition apparatus 30 is disposed on the battery cell housing to achieve acquisition of data information such as voltage of the battery cell 20.

Alternatively, when the battery cell housing is not energized, the battery module 40 further includes a battery cell connecting sheet 42, and the battery cell connecting sheet 42 is electrically connected to an acquisition circuit board 31 of the acquisition circuit board element 33. The acquisition circuit board element 33 is disposed at a position, corresponding to a negative electrode of the battery cell 20, of the battery cell connecting sheet 42, and the acquisition circuit board element 33 is disposed between two adjacent battery cells 20 with opposite polarities. One end of the battery cell connecting sheet 42 is connected to the battery cell 20, and the other end of the battery cell connecting sheet 42 is electrically connected to the acquisition circuit board 31. For example, each terminal 201 of the battery cell 20 is connected to a battery cell connecting sheet 42, and the other end of the battery cell connecting sheet 42 is electrically connected to the acquisition circuit board 31. That is, the battery cell 20 and the acquisition circuit board 31 are electrically connected via the battery cell connecting sheet 42. Each battery cell 20 corresponds to one acquisition circuit board element 33. The acquisition circuit board elements 33 are arranged on different sides of an arrangement direction of the battery cells 20, and two adjacent acquisition circuit board elements 33 are disposed in a staggered manner along a direction perpendicular to the arrangement direction of the battery cells 20.

The battery module 40 further includes a sampling nickel sheet 43, and the sampling nickel sheet 43 is disposed between the battery cell connecting sheet 42 and the acquisition circuit board 31. That is, the acquisition circuit board 31 is disposed between two terminals 201 of the battery cells 20. The battery cell connecting sheet 42 and the sampling nickel sheet 43 are disposed between the acquisition circuit board 31 and the terminal 201. The battery cell connecting sheet 42 is configured to connect the sampling nickel sheet 43 and the terminal 201 of the battery cell 20, the sampling nickel sheet 43 is configured to connect the acquisition circuit board 31 and the battery cell connecting sheet 42, and the sampling nickel sheet 43 is configured to sample the voltage of the battery cell 20. The sampling nickel sheet 43 is welded to the battery cell connecting sheet 42 and the acquisition circuit board 31. In this way, arrangement of the sampling nickel sheet 43 facilitates electrical connection between the battery cell connecting sheet 42 and the acquisition circuit board 31, and facilitates sampling of data such as voltage from the battery cell 20.

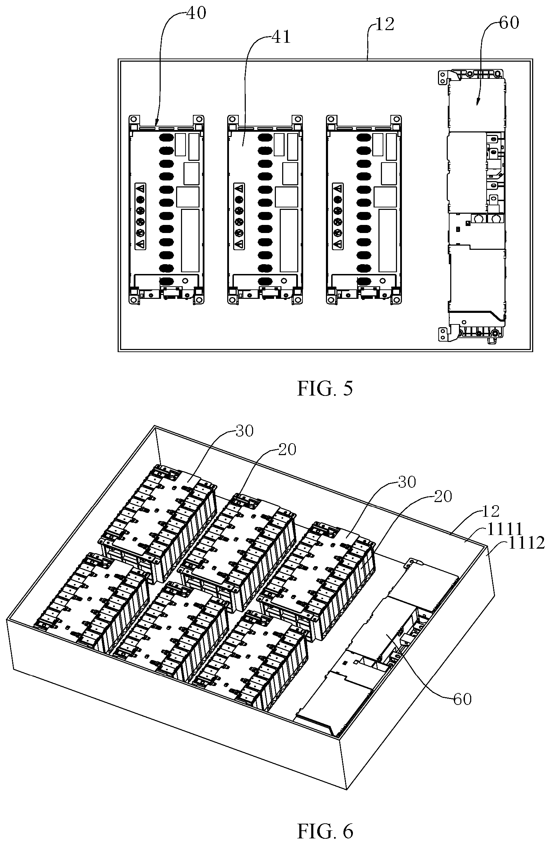

In some embodiments, as shown in FIG. 1 and FIG. 5, the acquisition apparatus 30 includes an antenna 50; and the antenna 50 is disposed on the battery module 40, for example, the antenna 50 is disposed outside the battery module 40 or inside the battery module 40.

In some embodiments, as shown in FIG. 5 to FIG. 7, the antenna 50 is disposed on the acquisition circuit board 31 of the acquisition apparatus 30. In this case, the antenna 50 is fastened to the acquisition circuit board 31, and the antenna 50 is closer to the acquisition circuit board 31 to better acquire the signals emitted by the transmitter 34. The acquisition circuit board 31 is a rigid printed circuit board.

In some embodiments, a mounting bracket 401 is disposed inside the battery module 40, and the antenna 50 is disposed on the mounting bracket 401. For example, the mounting bracket 401 is disposed outside the battery cell 20, and the antenna 50 can be connected to the mounting bracket 401, so that the mounting bracket 401 supports and mounts the antenna 50, simplifying a mounting structure of the antenna 50.

In some embodiments, as shown in FIG. 1, FIG. 5, FIG. 10, and FIG. 13, the battery module 40 further includes at least one battery cell 20 and a module housing 41. The battery cell 20 is disposed inside the module housing 41, and the antenna 50 is disposed on one side, away from the battery cell 20, of the module housing 41, or the antenna 50 is disposed on one side, adjacent to the battery cell 20, of the module housing 41. That is, the module housing 41 defines a cavity, the battery cell 20 is disposed inside the cavity, and the antenna 50 can be disposed outside the module housing 41 or inside the module housing 41 and is connected to the module housing 41. In this embodiment, a groove, a clip, or an adhesive can be disposed on an exterior of the module housing 41. The antenna 50 can be detachably fitted into the groove to achieve mounting of the antenna 50. The acquisition apparatus 30 where the transmitter 34 is located is disposed inside the module housing 41 and is electrically connected to the battery cell 20. The signals emitted by the transmitter 34 are converted by the antenna 50 into differential signals for transmission to the receiver 601. The signals are analyzed and processed by the BMU to achieve control over the battery cell 20.

In this way, when the antenna 50 is disposed on the battery module 40, the antenna 50 can be disposed inside or outside the module housing 41 of the battery module 40, both achieving signal transmission between the antenna 50 and the transmitter 34. A specific position where the antenna 50 is disposed can be selected on the basis of a usage scenario.

In some embodiments, as shown in FIG. 8, the battery cell 20 includes two terminals 201, the two terminals 201 are disposed at the same end of the battery cell 20, and the antenna 50 is disposed between the two terminals 201. In this way, the antenna 50 is positioned adjacent to the terminal 201 and is located between the two terminals 201, facilitating shortening a distance between the antenna 50 and the terminal 201 and optimizing the arrangement of the antenna 50, so that the acquisition of data information of the battery cell 20 by the acquisition apparatus 30 is more timely and efficient, facilitating increase in a transmission rate.

In some embodiments, as shown in FIG. 6 to FIG. 9, the acquisition circuit board 31 is disposed in the middle of the battery module 40, and the antenna 50 is opposite to the acquisition circuit board 31. The acquisition circuit board 31 is disposed in the middle of the battery module 40. For example, the acquisition circuit board 31 is disposed between the two terminals 201 of the battery cell 20. The terminals 201 are electrically connected to the acquisition circuit board 31, so that the acquisition chip 32 disposed on the acquisition circuit board 31 can acquire the data information of the battery cell 20. In this way, the antenna 50 is opposite to the acquisition circuit board 31, so that the antenna 50 can be located within a signal coverage area of the transmitter 34 disposed on the acquisition circuit board 31, facilitating communication between the antenna 50 and the transmitter 34.

In some embodiments, there are a plurality of battery cells 20, and the plurality of battery cells 20 are electrically connected to at least one acquisition chip 32. That is, there are a plurality of battery cells 20 inside the battery module 40, an acquisition apparatus 30 is disposed on each battery cell 20, and each acquisition apparatus 30 is electrically connected to a corresponding battery cell 20. In this way, each battery cell 20 corresponds to one acquisition chip 32, so that the acquisition chip 32 can accurately identify data information of the corresponding battery cell 20 and transmit the data information acquired thereby to the BMU.

Furthermore, for the acquisition element formed by integrating the acquisition chip 32 and the transmitter 34, the transmitter 34 is integrated onto the acquisition chip 32, and the acquisition chip 32 is directly electrically connected to the battery cell 20 or electrically connected to the battery cell 20 via the battery cell connecting sheet 42, to achieve the acquisition of the data information of the battery cell 20.

In some embodiments, there are a plurality of battery cells 20, and the plurality of battery cells 20 are electrically connected to at least one acquisition circuit board 31. For example, the battery module 40 includes a plurality of battery cells 20 therein, some of the plurality of battery cells 20 corresponds to one acquisition circuit board 31, and the acquisition circuit board 31 is electrically connected to the plurality of battery cells 20. In this way, one acquisition circuit board 31 corresponds to the plurality of battery cells 20, facilitating arrangement of the acquisition circuit board 31 on the battery cells 20, reducing the costs of the battery module 40, and facilitating simultaneous acquisition of data from the plurality of battery cells 20 by the acquisition chip 32 to improve the acquisition efficiency.

As shown in FIG. 9, when the plurality of battery cells 20 are disposed in the form of modules inside the battery pack 100, each battery module 40 corresponds to at least one acquisition circuit board 31. In this case, the acquisition circuit board 31 may be an FPC (Flexible Printed Circuit: flexible printed circuit board) or a BIC (Battery Information Collector: rigid printed circuit board). The acquisition chip 32 and the transmitter 34 can be integrated onto the acquisition circuit board. The antenna 50 passes sequentially through the module housings 41 of a plurality of battery modules 40, and the antenna 50 is fastened by bonding or clipping. The method for mounting and fastening the antenna 50 and the structure thereof are simple and convenient, facilitating arrangement of the antenna 50 and improving the mounting efficiency of the battery pack 100.

According to the embodiment in a third aspect of this application, the battery pack 100 includes: a housing 10, at least one battery cell 20, and an acquisition apparatus 30. The battery cell 20 is disposed inside the housing 10. The acquisition apparatus 30 is the acquisition apparatus 30 according to any one of the foregoing embodiments. One end of the acquisition apparatus 30 is electrically connected to the battery cell 20.

In this embodiment, the battery module 40 is not provided inside the battery pack 100. That is, when the plurality of battery cells 20 disposed inside the battery pack 100 are not disposed in the form of a module, an acquisition circuit board 31 can be a rigid printed circuit board. The rigid printed circuit board is disposed inside the battery pack 100 or on the battery cells 20, to facilitate connection of the battery cells 20 to the acquisition circuit board 31. The acquisition circuit board 31 of each acquisition apparatus can be electrically connected to the plurality of battery cells 20, to achieve synchronous acquisition of data information of the plurality of battery cells 20. In some optional embodiments, each battery cell 20 corresponds to one acquisition apparatus.

According to the battery pack 100 in the embodiment of this application, the acquisition apparatus 30 is disposed inside the battery pack 100, so that wireless communication between the battery cell 20 and the BMS in the battery pack 100 is achieved, reducing a number of wiring harnesses used for electrical connection between the BMS and the battery cell 20 and optimizing the layout of the battery cell 20 inside the battery pack 100.

In some embodiments, as shown in FIG. 1 and FIG. 2 and with reference to FIG. 12, the battery pack 100 further includes an antenna 50, and the antenna 50 communicates with a transmitter 34 disposed inside the acquisition apparatus 30. The housing 10 includes a tray 12 and a cover plate 11. One side of the tray 12 is open, and the cover plate 11 is disposed the open side of the tray 12. The cover plate 11 and the tray 12 jointly define an accommodating cavity. The battery cell 20 is disposed inside the accommodating cavity, and the antenna 50 is disposed on the tray 12 or the cover plate 11.

The plurality of battery cells 20 are arranged in the accommodating cavity. When the terminals 201 of the battery cells 20 are disposed toward the cover plate 11, the acquisition circuit board 31 included by the acquisition apparatus 30 is disposed between the terminals 201 of the battery cells 20, and the antenna 50 can be disposed on the cover plate 11 to reduce the distance between the antenna 50 and the transmitter 34 included by the acquisition apparatus 30, so that the antenna 50 can better receive the signals transmitted by the transmitter 34. When the terminals 201 of the battery cells 20 are disposed toward one side of the tray 12, the acquisition circuit board 31 included by the acquisition apparatus 30 is disposed between the terminals 201 of the battery cells 20, and the antenna 50 can be disposed on the tray 12. For example, a groove is formed in one side, adjacent to the battery cells 20, of the tray 12, and the antenna 50 can be fitted into the groove, reducing the space occupied by the antenna 50 inside the accommodating cavity and facilitating mounting and fastening of the antenna 50. Alternatively, the antenna 50 is directly disposed on a side surface, adjacent to the battery cell 20, of the tray 12, and is connected by clipping, bonding, or the like.

In this way, when the battery cells 20 are disposed inside the accommodating cavity, the position of the antenna 50 can be selected on the basis of the positions where the terminals 201 on the battery cells 20 are disposed, so that the antenna 50 and the transmitter 34 can be kept within a reasonable range, facilitating communication between the antenna 50 and the transmitter 34. Therefore, the data acquired from the battery cells 20 by the acquisition chip 32 can be transmitted to the antenna 50 in a timely and efficient manner, and then transmitted to the BMS via the antenna 50 to achieve reading and analysis of the data of the battery cells 20, thereby achieving adjustment of an interior of the battery pack 100.

As shown in FIG. 6 and FIG. 7, when the plurality of battery cells 20 are disposed inside the battery pack 100, but are not in the form of modules, the antenna 50 can be fastened to the acquisition circuit board 31 or to the cover plate 11 of the battery pack 100. The acquisition circuit board 31 is a BIC circuit board. In this case, one end of the terminals 201 of the plurality of battery cells 20 is disposed toward the cover plate 11. The acquisition circuit board 31 is disposed between the battery cells 20 and the cover plate 11. The acquisition circuit board 31 is electrically connected to the terminals 201. The antenna 50 passes sequentially through the plurality of acquisition circuit boards 31, and acquires data from the battery cells 20 via the transmitter 34 disposed on each acquisition circuit board 31.

With reference to FIG. 2 and FIG. 13, in this embodiment, when the plurality of battery cells 20 are disposed inside the battery pack 100 and arranged inside the battery pack 100, the plurality of battery cells 20 include at least one battery cell group; the battery cell group includes a plurality of battery cells 20; the battery cell group corresponds to at least one acquisition circuit board 31; and the acquisition circuit board 31 may be a BIC (Battery Information Collector: rigid printed circuit board). Alternatively, the plurality of battery cells 20 include a plurality of battery cell groups, the plurality of battery cell groups are arranged inside the battery pack 100, and each battery cell group corresponds to at least one acquisition circuit board 31. The acquisition circuit board 31 is disposed at one end, where the terminal 201 is disposed, of the battery cell 20, and the end is electrically connected to the acquisition circuit board 31. The acquisition chip 32 and the transmitter 34 are integrated onto the acquisition circuit board 31. Both the acquisition chip 32 and the transmitter 34 are electrically connected to the acquisition circuit board 31. The acquisition chip 32 can acquire the data information of the plurality of corresponding battery cells 20. The acquisition chip 32 may be an AFE chip (Analog Front End: battery sampling chip). The acquisition chip 32 can acquire the data information of the plurality of battery cells 20 and process the data information to form signals for the transmitter 34 to transmit. The receiver 601 receives the signals emitted by the transmitter 34 and transmits the signals to a control apparatus 60.

Optionally, at least one of the cover plate 11 and the tray 12 includes a first housing layer and a second housing layer, the first housing layer is located on one side, away from the battery cell 20, of the second housing layer, and the antenna 50 is disposed between the first housing layer and the second housing layer. For example, the cover plate 11 includes a first housing layer and a second housing layer, and the antenna 50 is disposed between the first housing layer and the second housing layer, so that the antenna 50 is located inside a sealed housing 10 defined by the first housing layer and the second housing layer, avoiding possible corrosion to the antenna 50 under the influence of moisture and other factors and thereby avoiding affecting the capability of the antenna 50 to receive and transmit signals. The first housing layer and the second housing layer are connected to form the cover plate 11 by gluing or hot pressing.

In some optional embodiments, the antenna 50 is disposed on one side, away from the second housing layer, of the first housing layer; or the antenna 50 is disposed on one side, away from the first housing layer, of the second housing layer. That is, the antenna 50 is disposed on one side, away from the second housing layer, of the first housing layer, or on one side, away from the first housing layer, of the second housing layer. On a surface of the first housing layer or a side surface of the second housing layer, the antenna 50 is disposed on either side of the cover plate 11 in a thickness direction by clipping, bonding, or the like.

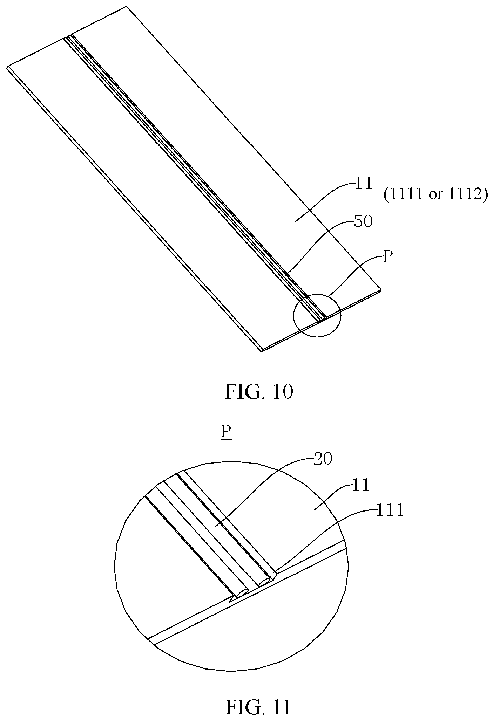

In some embodiments, with reference to FIG. 10 and FIG. 11, an accommodating groove 111 for accommodating at least a portion of the antenna 50 is formed in at least one of the first housing layer and the second housing layer. That is, the accommodating groove 111 can be formed in one side, facing the second housing layer, of the first housing layer, or the accommodating groove 111 can be formed in one side, facing the first housing layer, of the second housing layer. For example, the cover plate 11 includes a first housing layer 1111 and a second housing layer 1112: the accommodating groove 111 is formed in the first housing layer 1111, and the accommodating groove 111 can be formed by sinking from one side, close to the second housing layer 1112, of the first housing layer 1111 to one side away from the second housing layer 1112; or the accommodating groove 111 is formed in the second housing layer 1112, and the accommodating groove 111 can be formed by sinking from one side, close to the first housing layer 1111, of the second housing layer 1112 to one side away from the first housing layer 1111. In this way, arrangement of the accommodating groove 111 facilitates the mounting of the antenna 50 between the first housing layer 1111 and the second housing layer 1112, facilitates protection and sealing of the antenna 50, and reduces corrosion caused by environmental factors to the antenna 50.

In some embodiments, with reference to FIG. 1, FIG. 7, and FIG. 12, the battery pack 100 further includes the control apparatus 60, the control apparatus 60 is disposed inside the housing 10, the control apparatus 60 includes the receiver 601, and the antenna 50 communicates with the receiver 601. The battery management system includes the control apparatus 60, and the signals transmitted by the transmitter 34 are transmitted to the battery management system to facilitate the acquisition of the data information of the battery cell 20, thereby achieving the control over the battery cell 20.

In some embodiments, the control apparatus 60 includes a main positive terminal and a main negative terminal, and the two ends of the antenna 50 are electrically connected to the main positive terminal and the main negative terminal respectively. For example, the antenna 50 is led out from the main negative terminal of the control apparatus 60, enters the accommodating groove 111 in the cover plate 11 of the battery pack 100, passes sequentially through the acquisition circuit boards 31 corresponding to the plurality of battery cells 20 or the acquisition circuit boards 31 corresponding to the plurality of battery modules 40, and then returns to the main positive terminal of the control apparatus 60. The antenna 50 is opposite to the transmitter 34 disposed on each acquisition circuit board 31. Each transmitter 34 can locally send the data information acquired by the acquisition chip 32 from the battery cell 20 to the antenna 50 adjacent thereto. FIG. 1 shows a schematic diagram of a specific routing of the antenna 50 according to this application. However, the scope of protection of this application is not limited to a number of battery cells 20 inside the battery pack 100, a number and the arrangement positions of the acquisition circuit boards 31, and a specific path of the antenna 50 inside the battery pack 100. In this way, the arrangement of the antenna 50 can facilitate layout and wiring routing thereof in the battery pack 100, with higher flexibility and lower costs.

According to the embodiment in a fourth aspect of this application, the battery pack 100 includes: at least one battery module 40 and a control apparatus 60. The battery module 40 is the battery module 40 according to any one of the foregoing embodiments. An acquisition apparatus 30 is arranged inside the battery module 40. The acquisition apparatus 30 includes a transmitter 34 and an antenna 50. The control apparatus 60 is provided with a receiver 601, and the receiver 601 communicates with the transmitter 34 via the antenna 50.

In this embodiment, the battery module 40 is disposed inside the battery pack 100; each battery module 40 includes a plurality of battery cells 20; each battery cell 20 corresponds to one acquisition apparatus 30, or the plurality of battery cells 20 correspond to one acquisition apparatus 30, depending on the capabilities of the acquisition apparatus 30 to acquire and process the data information of the battery cell 20; and no specific limitation is made herein. Taking the plurality of battery cells 20 corresponding to one acquisition apparatus 30 as an example, each battery module 40 corresponds to at least one acquisition apparatus 30. The acquisition apparatus 30 can be disposed inside or outside a module housing 41 of the battery module 40, and the antenna 50 is connected to the module housing 41 by clipping or bonding. The antenna 50 passes sequentially through a plurality of battery modules 40, and passes through the plurality of battery cells 20, so that the transmitters 34 disposed inside a plurality of acquisition apparatuses 30 and the antenna 50 can be always kept within a communication range, ensuring the stability of a signal transmission process. The control apparatus 60 can be disposed between the battery module 40 and a side wall of the tray 12 inside the battery pack 100. The control apparatus 60 can acquire data from the battery cell 20 via the antenna 50 and the transmitter 34 and the receiver 601 that communicate with the antenna 50.

The battery management system (BMS) is disposed inside the battery pack 100. The battery management system (BMS) is mainly configured to perform real-time monitoring of parameters such as total voltage, total current, cell voltage, cell temperature, and capacity in the battery pack, fault diagnosis, SOC estimation, driving range estimation, short-circuit protection, leakage monitoring, equalization control, selection of charge and discharge control modes, and the like, and also to interact with a vehicle integrated controller or a motor via a CAN bus to ensure efficient and reliable operation of an electric vehicle. The battery management system includes the control apparatus 60. A working principle is to determine the state and health condition of the battery cell 20 by reading parameters such as voltage, current and temperature of the battery cell 20, and to perform charge and discharge management as needed. Meanwhile, faults and abnormalities of the battery cell 20 can be also detected, and an alarm signal is sent out for timely handling.

According to an embodiment in a fifth aspect of this application, the vehicle 1000, as shown in FIG. 14, includes the battery pack 100 according to any one of the foregoing embodiments.

According to the vehicle 1000 in the embodiment of this application, wireless communication connection between a control apparatus 60 and a battery cell 20 inside the battery pack 100 of the vehicle is achieved via an acquisition apparatus 30, so that the control apparatus 60 can detect the battery cell 20 and acquire the data information of the battery cell 20. In this way, a number of wiring harnesses used for connection between the control apparatus 60 and the battery cell 20 is reduced, so that the space inside the battery pack 100 is optimized, and arrangement of the battery cell 20 inside the battery pack 100 is facilitated; the density of the battery cells 20 inside a same volume of the battery pack 100 is increased, and the capacity of the battery pack 100 is increased, so that the vehicle has a long driving range; furthermore, because of the wireless communication between the control apparatus 60 and the battery cell 20, the use of the wiring harnesses is reduced, so that the use safety of the battery pack 100 can be improved, thereby improving the use safety of the vehicle 1000.

In the description of this application, it should be understood that an orientation or a position relationship indicated by the term "center", "longitudinal", "lateral", "length", "width", "thickness", "upper", "lower", "front", "rear", "left", "right", "vertical", "horizontal", "top", "bottom", "inside", "outside", "clockwise", "counterclockwise", "axial", "radial", "circumferential", or the like is an orientation or a position relationship shown in the accompanying drawings, and is merely intended to facilitate the description and simplify the description of this application, but is not intended to indicate or imply that an apparatus or element in question must have a specific orientation and must be constructed and operated in a specific orientation. Therefore, such a term cannot be construed as a limitation on this application.

In the description of this application, a "first feature" or a "second feature" may include one or more such features. In the description of this application, "a plurality of" means two or more. In the description of this application, that the first feature is "above" or "below" the second feature may be that the first feature is in direct contact with the second feature, or may be that the first feature is not in direct contact with the second feature but in contact with the second feature through another feature between the first feature and the second feature. In the description of this application, that the first feature is "above", "over", or "on" the second feature may be that the first feature is right above or obliquely above the second feature, or merely mean that a horizontal height of the first feature is greater than that of the second feature.

In the description of this specification, description of the reference term such as "one embodiment", "some embodiments", "schematic embodiment", "example", "specific example", "some examples", or the like means that a specific feature, structure, material or characteristic described with reference to the embodiment or example is included in at least one embodiment or example of this application. In this specification, schematic representations of the foregoing terms do not necessarily mean a same embodiment or example.

Although the embodiments of this application have been shown and described, a person of ordinary skill in the art may understand that: various changes, modifications, substitutions, and variations may be made to these embodiments without departing from the principle and spirit of this application. The scope of this application is defined by the claims and their equivalents.

## Claims

1. An acquisition apparatus (30), comprising:
an acquisition chip (32), wherein the acquisition chip (32) is configured to electrically connect to at least one battery cell (20); and
a transmitter (34), wherein the transmitter (34) is electrically connected to the acquisition chip (32), and the transmitter (34) is configured to communicate with a receiver (601).

2. The acquisition apparatus (30) according to claim 1, further comprising: an acquisition circuit board (31), wherein the acquisition chip (32) and the transmitter (34) are both disposed on the acquisition circuit board (31), and the transmitter (34) and the acquisition chip (32) are both electrically connected to the acquisition circuit board (31).

3. The acquisition apparatus (30) according to claim 2, wherein the acquisition circuit board (31) is a flexible printed circuit board or a rigid printed circuit board.

4. The acquisition apparatus (30) according to any one of claims 1 to 3, further including an antenna (50), wherein at least a portion of the antenna (50) is disposed within a stable transmission area of differential signals emitted by the transmitter (34).

5. The acquisition apparatus (30) according to claim 4, wherein a distance between the antenna (50) and the transmitter (34) is L, and L satisfies: 0≤L≤100 mm.

6. The acquisition apparatus (30) according to claim 4 or 5, wherein the antenna (50) comprises a plurality of differential signal lines (52), and the plurality of differential signal lines (52) communicate wirelessly with the transmitter (34).

7. The acquisition apparatus (30) according to claim 6, wherein the antenna (50) further comprises:
at least one shielding wire (51), wherein the shielding wire (51) and the plurality of the differential signal lines (52) are disposed side by side.

8. The acquisition apparatus (30) according to claim 7, wherein there are a plurality of shielding wires (51), and the plurality of shielding wires (51) are separately located on two sides of an arrangement direction of the plurality of differential signal lines (52).

9. The acquisition apparatus (30) according to any one of claims 4 to 8, wherein an outer side of the antenna (50) is wrapped with a cable.

10. A battery module (40), comprising:
an acquisition apparatus (30), wherein the acquisition apparatus (30) is the acquisition apparatus (30) according to any one of claims 1 to 9.

11. The battery module (40) according to claim 10, wherein the acquisition apparatus (30) is disposed on the battery module (40); or
the battery module (40) further comprises: a battery cell connecting sheet (42), wherein the battery cell connecting sheet (42) is electrically connected to an acquisition circuit board (31) of the acquisition apparatus (30).

12. The battery module (40) according to claim 11, further comprising: a sampling nickel sheet (43), wherein the sampling nickel sheet (43) is disposed between the battery cell connecting sheet (42) and the acquisition circuit board (31).

13. The battery module (40) according to any one of claims 10 to 12, wherein the acquisition apparatus (30) comprises: an antenna (50), wherein the antenna (50) is disposed on the battery module (40); or
the antenna (50) is disposed on the acquisition circuit board (31) of the acquisition apparatus (30); or
a mounting bracket (401) is disposed inside the battery module (40), and the antenna (50) is disposed on the mounting bracket (401).

14. The battery module (40) according to claim 13, wherein the battery module (40) further comprises:
at least one battery cell (20); and
a module housing (41), wherein the battery cell (20) is disposed inside the module housing (41), and the antenna (50) is disposed on one side, away from the battery cell (20), of the module housing (41); or
the antenna (50) is disposed on one side, adjacent to the battery cell (20), of the module housing (41).

15. The battery module (40) according to claim 14, wherein the battery cell (20) comprises two terminals (201), the two terminals (201) are disposed at a same end of the battery cell (20), and the antenna (50) is disposed between the two terminals (201).

16. The battery module (40) according to any one of claims 13 to 15, wherein the acquisition circuit board (31) is disposed in the middle of the battery module (40), and the antenna (50) is opposite to the acquisition circuit board (31).

17. The battery module (40) according to any one of claims 10 to 16, wherein there are a plurality of battery cells (20), and the plurality of battery cells (20) are electrically connected to at least one acquisition chip (32).

18. The battery module (40) according to any one of claims 10 to 17, wherein there are a plurality of battery cells (20), and the plurality of battery cells (20) are electrically connected to at least one acquisition circuit board (31).

19. A battery pack (100), comprising:
a housing (10);
at least one battery cell (20), wherein the battery cell (20) is disposed inside the housing (10); and
an acquisition apparatus (30), wherein the acquisition apparatus (30) is the acquisition apparatus (30) according to any one of claims 1 to 9, and one end of the acquisition apparatus (30) is electrically connected to the battery cell (20).

20. The battery pack (100) according to claim 19, further comprising: an antenna (50), wherein the antenna (50) communicates with a transmitter (34) disposed inside the acquisition apparatus (30); and
the housing (10) comprises:
a tray (12), wherein one side of the tray (12) is open; and
a cover plate (11), wherein the cover plate (11) is disposed on the open side of the tray (12), the cover plate (11) and the tray (12) jointly define an accommodating cavity, the battery cell (20) is disposed inside the accommodating cavity, and the antenna (50) is disposed on the tray (12) or the cover plate (11).

21. The battery pack (100) according to claim 20, wherein at least one of the cover plate (11) and the tray (12) comprises a first housing layer (1111) and a second housing layer (1112), the first housing layer (1111) is located on one side, away from the battery cell (20), of the second housing layer (1112), and the antenna (50) is disposed between the first housing layer (1111) and the second housing layer (1112); or
the antenna (50) is disposed on one side, away from the second housing layer (1112), of the first housing layer (1111); or
the antenna (50) is disposed on one side, away from the first housing layer (1111), of the second housing layer (1112).

22. The battery pack (100) according to claim 21, wherein an accommodating groove (111) for accommodating at least a portion of the antenna 50 is formed in at least one of the first housing layer (1111) and the second housing layer (1112).

23. The battery pack (100) according to any one of claims 20 to 22, further comprising: a control apparatus (60), wherein the control apparatus (60) is disposed inside the housing (10), the control apparatus (60) comprises a receiver (601), and the antenna (50) communicates with the receiver (601).

24. The battery pack (100) according to claim 23, wherein the control apparatus (60) comprises a main positive terminal and a main negative terminal, and two ends of the antenna (50) are electrically connected to the main positive terminal and the main negative terminal respectively.

25. A battery pack (100), comprising:
at least one battery module (40), wherein the battery module (40) is the battery module (40) according to any one of claims 10 to 18, an acquisition apparatus (30) is disposed inside the battery module (40), and the acquisition apparatus (30) comprises a transmitter (34) and an antenna (50); and
a control apparatus (60), wherein the control apparatus (60) is provided with a receiver (601), and the receiver (601) communicates with the transmitter (34) via the antenna (50).

26. A vehicle (1000), comprising the battery pack (100) according to any one of claims 19 to 24 or the battery pack (100) according to claim 25.
